(19) Europäisches Patentamt
European Patent Office
Office européen des brevets

(11) **EP 2 786 492 B1**

(12) **FASCICULE DE BREVET EUROPEEN**

(45) Date de publication et mention
de la délivrance du brevet:
**25.11.2015 Bulletin 2015/48**

(21) Numéro de dépôt: **12794341.3**

(22) Date de dépôt: **30.11.2012**

(51) Int Cl.:
*H03L 7/16* [(2006.01)]     *H04B 1/717* [(2011.01)]

(86) Numéro de dépôt international:
**PCT/EP2012/074136**

(87) Numéro de publication internationale:
**WO 2013/079685 (06.06.2013 Gazette 2013/23)**

(54) **DISPOSITIF ET PROCÉDÉ DE SYNTHÈSE DE FRÉQUENCE**

FREQUENZSYNTHESEVORRICHTUNG UND -VERFAHREN

FREQUENCY SYNTHESIS DEVICE AND METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **30.11.2011 FR 1160955**

(43) Date de publication de la demande:
**08.10.2014 Bulletin 2014/41**

(73) Titulaire: **Commissariat à l'Énergie Atomique
et aux Énergies Alternatives
75015 Paris (FR)**

(72) Inventeurs:
• **SILIGARIS, Alexandre
F-38100 Grenoble (FR)**
• **JANY, Clément
F-38000 Grenoble (FR)**

(74) Mandataire: **Ahner, Philippe et al
BREVALEX
95, rue d'Amsterdam
75378 Paris Cedex 8 (FR)**

(56) Documents cités:
**WO-A1-2008/069444     US-A1- 2009 175 116**

• **RUI XU ET AL: "Power-Efficient Switching-Based
CMOS UWB Transmitters for UWB
Communications and Radar Systems", IEEE
TRANSACTIONS ON MICROWAVE THEORY AND
TECHNIQUES, IEEE SERVICE CENTER,
PISCATAWAY, NJ, US, vol. 54, no. 8, 1 août 2006
(2006-08-01), pages 3271-3277, XP001545203,
ISSN: 0018-9480, DOI: 10.1109/TMTT.
2006.877830**
• **NAWREEN KHAN ET AL: "A Low Power
Frequency Synthesizer for 60-GHz Wireless
Personal Area Networks", IEEE TRANSACTIONS
ON CIRCUITS AND SYSTEMS II: EXPRESS
BRIEFS, IEEE, US, vol. 58, no. 10, 1 octobre 2011
(2011-10-01), pages 622-626, XP011363375, ISSN:
1549-7747, DOI: 10.1109/TCSII.2011.2164157**
• **RAMESH HARJANI ET AL: "Fast Hopping
Injection Locked Frequency Generation for
UWB", ULTRA-WIDEBAND, 2007. ICUWB 2007.
IEEE INTERNATIONAL CONFERENCE ON, IEEE,
PI, 1 septembre 2007 (2007-09-01), pages 502-507,
XP031159403, ISBN: 978-1-4244-0520-6**

**Description**

**DOMAINE TECHNIQUE**

L'invention concerne un dispositif et un procédé de synthèse de fréquence permettant de fournir un signal stable d'une certaine fréquence à partir d'un signal de fréquence inférieure. L'invention concerne également un dispositif d'émission et/ou de réception de signaux, fonctionnant par exemple dans le domaine radiofréquences (RF), comportant un tel dispositif de synthèse de fréquence destiné à fournir en sortie un signal périodique stable.

**ÉTAT DE LA TECHNIQUE ANTÉRIEURE**

Un dispositif de synthèse de fréquence permet de fournir un signal stable en fréquence destiné à être utilisé par exemple dans un système de communication RF. Ainsi, lors d'une émission de signaux, un signal contenant l'information à envoyer peut être modulé avec le signal stable en fréquence servant de signal porteur pour véhiculer l'information.

La synthèse de fréquence réalisée définit dans ce cas la valeur de la fréquence porteuse d'émission. Lors d'une réception de signaux, la synthèse de fréquence permet de fournir ce signal stable en fréquence pour démoduler l'information reçue.

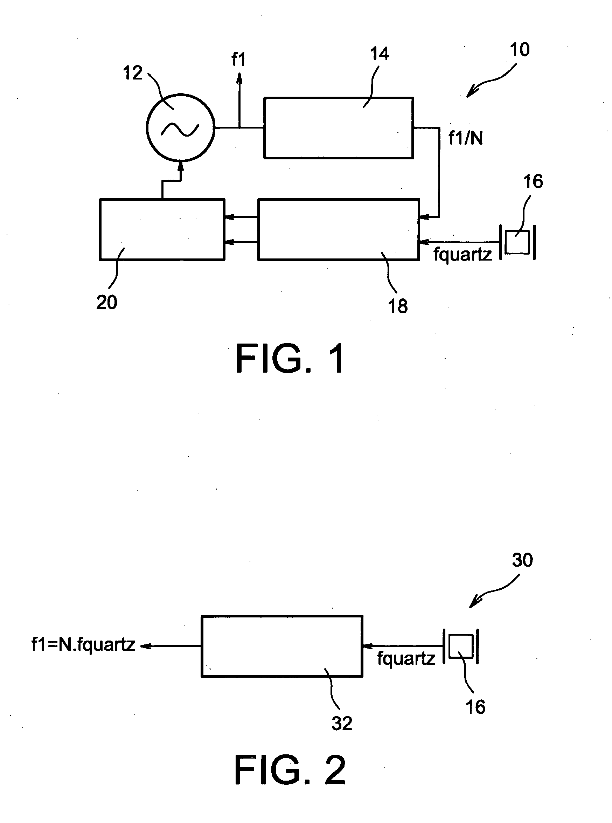

Un premier exemple de réalisation d'un dispositif de synthèse de fréquence 10, utilisé par exemple dans un système d'émission / réception à fréquence porteuse, est représenté sur la figure 1.

Le dispositif 10 comporte un oscillateur 12 commandé en tension (VCO pour « Voltage-Controlled Oscillator »), fournissant en sortie un signal sinusoïdal dont la fréquence d'oscillation est contrôlée par une tension appliquée en entrée de l'oscillateur 12. L'oscillateur 12 est réalisé tel qu'il puisse fournir en sortie un signal oscillant dans la bande des fréquences utilisées par le système de communication dont fait partie le dispositif 10. On considère que l'oscillateur 12 fournit en sortie un signal sinusoïdal de fréquence $f_1$.

Le signal de sortie fourni par l'oscillateur 12 seul est instable dans les bandes de fréquences RF et les micro-ondes, dérive dans le temps et présente une impureté spectrale (bruit de phase) élevée. Il est donc nécessaire de le stabiliser en fréquence en verrouillant (c'est-à-dire en fixant, ou synchronisant) sa phase sur celle d'un signal très stable en fréquence fourni par exemple par un résonateur de très haute qualité, tel qu'un résonateur à quartz, qui fonctionne toutefois à plus basse fréquence (généralement dans le domaine des MHz).

Afin de verrouiller la phase du signal délivré par l'oscillateur 12 et stabiliser ainsi la fréquence d'oscillation $f_1$ de ce signal, l'oscillateur 12 est asservi au sein d'une boucle à verrouillage de phase (PLL pour « Phase-Locked Loop »). Cette PLL comporte plusieurs diviseurs de fréquence reliés en série les uns aux autres (représentés sous la forme d'un seul élément référencé 14 sur la figure 1) et aptes à diviser ensemble la fréquence $f_1$ du signal délivré par l'oscillateur 12 par un nombre $N$ entier ou fractionnaire. On obtient en sortie des diviseurs de fréquence 14 un signal périodique de fréquence $f_1/N$ qui est ensuite comparé à un signal périodique de référence très stable, tel qu'un signal de fréquence $f_{quartz}$ fourni par un résonateur 16 à quartz. Les diviseurs de fréquence 14 sont réalisés tels que le facteur $N$ obtenu permette que la fréquence $f_1/N$ soit proche de la fréquence $f_{quartz}$. La comparaison entre ces deux signaux est réalisée par un comparateur de phases 18 (PFD pour « Phase Frequency Detector ») générant en sortie un signal proportionnel à la différence de phases mesurée entre ces deux signaux et dont la valeur est positive ou négative selon le signe de la différence $f_1/N-f_{quartz}$. Ce signal de sortie est envoyé en entrée d'un circuit de pompe de charge et d'un filtre 20 délivrant en sortie un signal appliqué sur l'entrée de commande de l'oscillateur 12 permettant d'ajuster sa fréquence d'oscillation de sorte à ce que $f_1/N=f_{quartz}$ une fois la boucle stabilisée.

Avec un tel dispositif de synthèse de fréquence 10, la stabilité en fréquence du signal de fréquence $f_1$ délivré par l'oscillateur 12, sa dérive dans le temps et sa pureté spectrale dépendent essentiellement des caractéristiques du signal de référence de fréquence $f_{quartz}$ fourni par le résonateur 16 ainsi que du rang de division N des diviseurs de fréquence 14. De plus, les fréquences synthétisées par le dispositif 10 dépendent également de la plage de fréquence d'oscillation de l'oscillateur 12 telles que :

$$f_{osc\,min} < N \cdot f_{quartz} < f_{osc\,max}$$

$f_{oscmin}$ et $f_{oscmax}$ étant respectivement les fréquences d'oscillation minimum et maximum de l'oscillateur 12.

L'oscillateur 12 est par exemple réalisé sous la forme de paires croisées différentielles (résonateur couplé avec une résistance négative). Les diviseurs de fréquence 14 utilisent différentes architectures selon qu'ils soient positionnés en début de chaîne (proche de la fréquence $f_1$, c'est-à-dire du côté de l'oscillateur 12) ou en fin de chaîne, à plus basse fréquence (proche de la fréquence $f_{quartz}$, c'est-à-dire du côté du comparateur de phases 18). Aux fréquences élevées, les diviseurs de fréquence utilisent des circuits de type CML (« Current Mode Logic ») ou ILFD (« Injection Locked Frequency Divider »). Les diviseurs de fréquence fonctionnant à plus basses fréquences utilisent des architectures purement numériques de type compteur. Les circuits formant les diviseurs de fréquence 14 peuvent être programmables afin que la valeur de la fréquence synthétisée par le dispositif 10 soit programmable ($f_1$ est dans ce cas un multiple de $f_{quartz}$) via le choix de la valeur de N (la valeur de $f_{quartz}$ est fonction de la nature du résonateur 16 et n'est donc pas programmable).

Ce type de dispositif de synthèse de fréquence 10 présente l'inconvénient majeur d'utiliser une longue chaîne de diviseurs de fréquence 14 compte tenu de la valeur importante de N lorsque la différence entre $f_{quartz}$ et $f_1$ est grande. Les premiers diviseurs de fréquence (ceux du côté de l'oscillateur 12) fonctionnant à hautes fréquences présentent une consommation électrique statique élevée. De plus, lorsque les premiers diviseurs de fréquence emploient une architecture de type ILFD, ils utilisent dans ce cas des éléments résonants (inductances ou lignes de transmission) occupant une surface de circuit importante. D'autre part, la PLL utilise une rétroaction qui agit sur la fréquence d'oscillation de l'oscillateur 12. Or, cette rétroaction peut mener la PLL à des instabilités (non verrouillage de la fréquence $f_1$) du fait que cette boucle fonctionne à haute fréquence.

Un deuxième exemple de réalisation d'un dispositif de synthèse de fréquence 30, utilisé dans un système d'émission / réception à fréquence porteuse élevée (domaine RF), est représenté sur la figure 2.

Par rapport au dispositif 10 précédemment décrit, ce deuxième dispositif de synthèse de fréquence 30 utilise une approche inverse consistant à multiplier la fréquence de référence $f_{quartz}$ jusqu'à obtention de la fréquence requise $f_1$. Comme représenté sur la figure 2, un tel dispositif 30 comporte un résonateur 16, par exemple similaire à celui du dispositif 10 précédemment décrit, délivrant en sortie le signal stable de référence de fréquence $f_{quartz}$. Ce signal est appliqué en entrée d'une chaîne de circuits multiplicateur de fréquence 32 de rang N (représentée sous la forme d'un seul élément sur la figure 2) apte à délivrer en sortie le signal de fréquence $f_1 = N.f_{quartz}$.

Le dispositif 30 ne comporte pas d'oscillateur ni de boucle à verrouillage de phase. Les premiers circuits multiplicateur de fréquences 32 (ceux se trouvant du côté du résonateur 16) fonctionnent à basses fréquences et utilisent des architectures numériques standards. Par contre, les circuits multiplicateur de fréquence 32 se trouvant en fin de chaîne fonctionnent à hautes fréquences et utilisent des architectures à verrouillage sous-harmonique, ou font appel à des techniques dites « push-push », à distorsion, à amplification harmonique ou autres. La stabilité et la pureté du signal (bruit de phase) de fréquence $f_1$ obtenu en sortie du dispositif de synthèse de fréquence 30 dépendent essentiellement des caractéristiques du signal stable de référence fourni par le résonateur 16 et du rang de multiplication N.

Lorsque le rang de multiplication N est élevé (ce qui est le cas pour un dispositif de synthèse de fréquence faisant partie d'un système de communication RF), il est nécessaire d'utiliser un nombre important de circuits multiplicateur de fréquence pour réaliser la chaîne 32, se traduisant par une consommation et une surface de circuit occupée importantes. De plus, il n'existe pas de circuit multiplicateur de fréquence programmable, ce qui rend le rang N fixe et ne permet pas au dispositif 30 de synthétiser des fréquences de manière programmable.

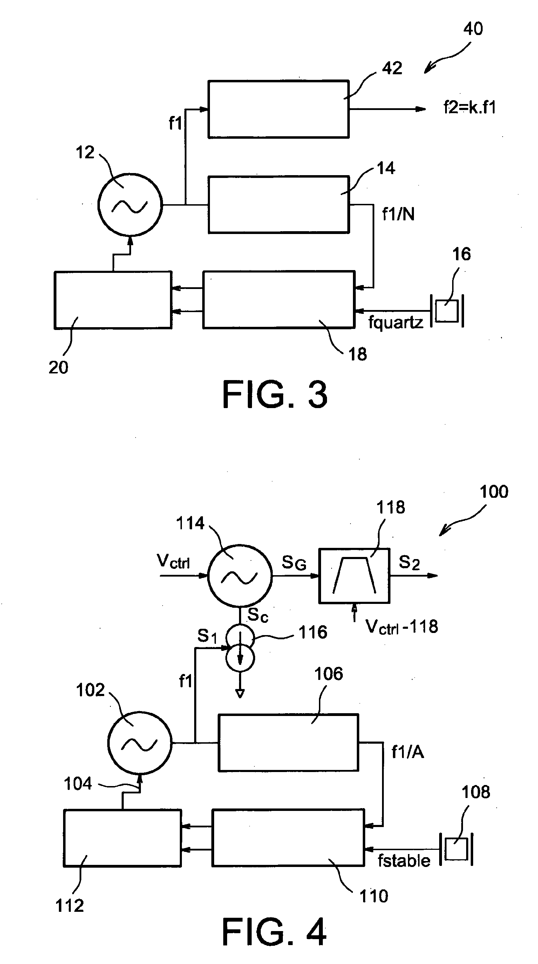

Un troisième exemple de réalisation d'un dispositif de synthèse de fréquence 40, utilisé par exemple dans un système d'émission / réception à fréquence porteuse élevée (RF), est représenté sur la figure 3.

L'architecture de ce dispositif 40 correspond à une combinaison des architectures des dispositifs de synthèse de fréquence 10 et 30 précédemment décrits. Une première synthèse de fréquence est effectuée à la fréquence $f_1$ en utilisant une architecture similaire à celle du dispositif 10 (en faisant appel à des éléments analogues aux éléments 12, 14, 16, 18, 20 du dispositif 10). Le signal de fréquence $f_1$ est ensuite multiplié par une chaîne de circuits multiplicateur de fréquence 42 de rang K afin d'obtenir en sortie un signal de fréquence $f_2 = K.f_1 = K.N.f_{quartz}$.

Un tel dispositif 40 a pour avantage de pouvoir synthétiser des fréquences programmables (via la programmation du paramètre N) et d'augmenter la valeur de la fréquence pouvant être obtenue en sortie. Les fréquences synthétisables sont telles que :

$$f_{osc\,min} < N \cdot K \cdot f_{quartz} < f_{osc\,max}$$

Bien que le dispositif de synthèse de fréquence 40 résolve une partie des inconvénients des dispositifs de synthèse de fréquence 10 et 30, tous ces dispositifs de synthèse de fréquence ont pour inconvénient de faire appel à des chaînes complètes de diviseurs et/ou multiplicateurs de fréquence de rangs élevés (*N* et *K* pouvant être de l'ordre de plusieurs centaines ou plusieurs milliers), en raison des grandes différences entre les valeurs des fréquences porteuses destinées à être obtenues en sortie des dispositifs et les fréquences relativement basses pouvant être fournies par des résonateurs stables tels que des résonateurs à quartz. Or, ces chaînes complètes de circuits diviseurs ou multiplicateurs de fréquence présentent une importante consommation électrique et occupent une surface de circuit également importante.

La publication de la demande de brevet WO 2008/069444 A1 décrit un dispositif de synthèse de fréquence qui utilise un signal d'entrée périodique de fréquence f pour générer un signal de sortie correspondant à un train d'oscillations de fréquence sensiblement égale à N.f, de durée inférieure à T = 1/f et répété périodiquement à la fréquence f , avec N nombre entier supérieur à 1.

## EXPOSÉ DE L'INVENTION

Un but de la présente invention est de proposer un nouveau type de dispositif de synthèse de fréquence ne présentant pas les inconvénients des dispositifs de synthèse de fréquence de l'art antérieur exposés précédemment.

La présente invention propose en outre un dispositif de synthèse de fréquence, comportant au moins :

- des premiers moyens, ou premier générateur, aptes à générer un signal périodique de fréquence $f_1$,
- des deuxièmes et troisièmes moyens, ou deuxième générateur, couplés aux premiers moyens et aptes à recevoir en entrée le signal périodique de fréquence $f_1$ et à générer un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
- des quatrièmes moyens, ou troisième générateur, aptes à générer, à partir du signal $S_G$, un signal périodique, par exemple sinusoïdal, dont le spectre fréquentiel comporte une raie principale, ou pic principal, de fréquence $f_2 = (N+i).f_1$, avec i nombre entier, en jouant un rôle de filtre passe-bande appliqué sur le signal SG et rejetant du spectre fréquentiel dudit signal périodique les raies autres que la raie principale dudit signal périodique.

Un tel dispositif permet de réaliser une synthèse de fréquence qui soit stabilisée en fréquence et en bruit. Ce dispositif se base sur une multiplication de fréquence d'un signal, ou plus particulièrement une génération, à partir d'une basse fréquence, d'un signal périodique complexe centré à plus haute fréquence, et une récupération de fréquence ultérieure afin d'obtenir un signal stabilisé en fréquence. En effet, les deuxièmes et troisièmes moyens génèrent, par exemple via la commande réalisée par les troisièmes moyens sur les deuxièmes moyens, un signal périodique impulsionnel dont la fréquence centrale $f_G$ est un multiple d'un premier signal généré de fréquence $f_1$. Les troisièmes moyens peuvent agir sur les deuxièmes moyens comme un interrupteur de commande fonctionnant à la fréquence $f_1$. On retrouve ainsi dans le spectre du signal délivré par les deuxièmes moyens et troisièmes moyens, correspondant par exemple à un signal sinusoïdal impulsionnel, ou plus généralement un signal correspondant à un train d'oscillations de fréquence sensiblement égale à $N.f_1$, de durée $T_H$ inférieure à $T_1 = 1/f_1$ et répété périodiquement à la fréquence $f_1$, avec N nombre entier supérieur à 1, plusieurs raies centrées autour de la fréquence centrale $f_G = N.f_1$ et espacées de $f_1$ les unes des autres. Les quatrièmes moyens servent ensuite à récupérer dans ce spectre la raie souhaitée et générer en sortie un signal périodique, par exemple sinusoïdal ou de forme sensiblement sinusoïdale, stable de fréquence centrale $f_2 = (N+i).f_1$.

Le dispositif selon l'invention permet donc de réaliser une synthèse haute fréquence ($f_2$) à partir d'un signal basse fréquence (fréquence $f_1$) et d'un générateur d'impulsions haute fréquence formé par les deuxièmes et troisièmes moyens.

Le dispositif selon l'invention permet de réaliser, entre la fréquence $f_1$ et la fréquence $f_2$ délivrée, une multiplication de fréquence d'ordre élevé sans présenter les inconvénients des multiplicateurs de fréquence de l'art antérieur. Le dispositif selon l'invention n'utilise pas de chaîne de multiplicateurs de fréquence traditionnels comme dans certains des dispositifs de synthèse de fréquence de l'art antérieur et a donc pour avantage de réduire la consommation et la taille du dispositif de synthèse de fréquence. De plus, la fréquence synthétisée est programmable via la programmation des paramètres $N$ et $i$.

Le dispositif selon l'invention a donc pour avantages, par rapport aux dispositifs de synthèse de fréquence de l'art antérieur comportant de longues chaînes de circuits multiplicateurs ou diviseurs de fréquence, de réduire la consommation électrique du dispositif, d'améliorer les performances de la synthèse de fréquence réalisée en termes de bruit de phase et de plage de fonctionnement fréquentiel, et de réduire également la complexité du design du dispositif.

Le dispositif de synthèse de fréquence selon l'invention ne fait pas appel à une longue chaîne de diviseurs de fréquence (source de consommation et de surface occupée importantes), ni à une PLL fonctionnant à haute fréquence (source d'instabilités à haute fréquence).

Le signal délivré par les quatrièmes moyens peut correspondre à un signal périodique dont le spectre fréquentiel comporte des raies de fréquences multiples entiers de $f_1$ et dont la raie principale (présentant la plus grande amplitude parmi l'ensemble des raies spectrales) est à la fréquence $f_2=(N+i)f_1$.

Les deuxièmes moyens peuvent comporter au moins un oscillateur commandé en tension dont la plage d'oscillation libre inclut la fréquence centrale $f_G$, c'est-à-dire $N.f_1$, la valeur de $N$ pouvant être fonction d'une valeur d'une première tension de commande destinée à être appliquée en entrée de l'oscillateur commandé en tension. La plage d'oscillation libre peut être définie comme étant la gamme de fréquences comprises entre la fréquence minimale et la fréquence maximale atteignables par l'oscillateur commandé en tension en fonction de la première tension de commande.

Les troisièmes moyens peuvent être aptes à générer une tension d'alimentation des deuxièmes moyens sous la forme d'un autre signal périodique de fréquence $f_1$ dont le rapport cyclique peut être inférieur à 1.

Les troisièmes moyens peuvent comporter au moins un interrupteur relié à une entrée d'alimentation électrique des deuxièmes moyens et apte à être commandé par le signal périodique de fréquence $f_1$ destiné à être généré par les premiers moyens.

Les troisièmes moyens peuvent comporter au moins un interrupteur relié à une entrée d'alimentation électrique de l'oscillateur et apte à être commandé par le signal périodique de fréquence $f_1$ tel qu'il génère une tension d'alimentation de l'oscillateur non nulle seulement pendant une partie de chaque période $T_1$.

Les troisièmes moyens peuvent comporter au moins un interrupteur relié à une sortie de l'oscillateur et apte à être commandé par le signal périodique de fréquence $f_1$ tel qu'il coupe une liaison électrique entre la sortie de l'oscillateur et l'entrée des quatrièmes moyens pendant une partie de chaque période $T_1$.

Les quatrièmes moyens peuvent comporter au moins un oscillateur verrouillé par injection destiné à recevoir en entrée le signal périodique impulsionnel de fréquence centrale $f_G$ (qui est périodiquement interrompu à la fréquence $f_1$) généré par les deuxièmes moyens, ou le signal $S_G$, et à être verrouillé au moins périodiquement à la fréquence $f_2$, la valeur de i pouvant être fonction d'une valeur d'une deuxième tension de commande destinée à être appliquée en entrée de l'oscillateur verrouillé par injection. Ce ou ces oscillateurs verrouillés par injection peuvent réaliser une récupération d'au moins une des raies, correspondant à la fréquence $f_2$, du spectre du signal délivré par les deuxièmes moyens.

Les quatrièmes moyens peuvent comporter au moins un filtre passe-bande de fréquence centrale sensiblement égale à $f_2$.

La valeur de la fréquence $f_1$ peut être supérieure à environ 1 GHz, et/ou la valeur de la fréquence $f_2$ peut être supérieure à environ 10 GHz, et/ou le signal périodique impulsionnel généré par les deuxièmes moyens peut être un signal sinusoïdal impulsionnel, et/ou les oscillations du signal $S_G$ peuvent être sinusoïdales, et/ou le signal périodique de fréquence $f_2$, ou plus généralement le signal périodique dont le spectre fréquentiel comporte une raie principale de fréquence $f_2$, peut être un signal sensiblement sinusoïdal.

Les premiers moyens peuvent comporter au moins un dispositif résonateur et une boucle à verrouillage de phase apte à asservir la phase du signal périodique de fréquence $f_1$ délivré par un oscillateur commandé en tension de la boucle à verrouillage de phase sur une phase d'un signal périodique, par exemple un signal sinusoïdal, délivré par le dispositif résonateur. Ainsi, le dispositif de synthèse de fréquence peut faire appel à une boucle à verrouillage de phase fonctionnant à basse fréquence, ce qui permet de supprimer les risques d'instabilité engendrés par une PLL fonctionnant à une haute fréquence comme dans l'art antérieur.

En variante, les premiers moyens peuvent également comporter un dispositif résonateur apte à générer le signal périodique, qui est stable, de fréquence $f_1$.

L'invention concerne également un dispositif d'émission et/ou de réception de signaux, comportant au moins un dispositif de synthèse de fréquence tel que défini précédemment et couplé à un modulateur et/ou un démodulateur du dispositif d'émission et/ou de réception.

La présente invention concerne également un procédé de synthèse de fréquence, comportant au moins les étapes de :

- génération d'un signal périodique de fréquence $f_1$,
- génération, à partir du signal périodique de fréquence $f_1$, d'un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
- génération, à partir du signal $S_G$, d'un signal périodique dont le spectre fréquentiel comporte une raie principale de fréquence $f_2 = (N+i).f_1$, avec i nombre entier, via la mise en oeuvre d'une fonction de filtrage passe-bande appliquée sur le signal SG et rejetant du spectre fréquentiel dudit signal périodique les raies autres que la raie principale dudit signal périodique.

L'invention concerne enfin un procédé de réalisation d'un dispositif de synthèse de fréquence, comportant au moins les étapes de :

- réalisation de premiers moyens aptes à générer un signal périodique de fréquence $f_1$,
- réalisation de deuxièmes et troisièmes moyens, couplés aux premiers moyens et aptes à recevoir en entrée le signal périodique de fréquence $f_1$ et à générer un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
- réalisation de quatrièmes moyens aptes à générer, à partir du signal $S_G$, un signal périodique dont le spectre fréquentiel comporte une raie principale de fréquence $f_2 = (N+i).f_1$. avec i nombre entier, en jouant un rôle de filtre passe-bande appliqué sur le signal SG et rejetant du spectre fréquentiel dudit signal périodique les raies autres que la raie principale dudit signal périodique.

## BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

- les figures 1 à 3 représentent schématiquement des dispositifs de synthèse de fréquence selon l'art antérieur,
- la figure 4 représente schématiquement un dispositif de synthèse de fréquence, objet de la présente invention, selon un premier mode de réalisation,
- les figures 5A et 5B représentent respectivement la forme d'onde et le spectre d'un signal $S_C$ généré dans un dispositif de synthèse de fréquence, objet de la présente invention,
- les figures 6A et 6B représentent respectivement la forme d'onde et le spectre d'un signal $S_G$ généré dans un dispositif de synthèse de fréquence, objet de la présente invention,
- les figures 7A et 7B représentent respectivement la forme d'onde et le spectre d'un signal $S_2$ obtenu en sortie d'un dispositif de synthèse de fréquence, objet de la présente invention,
- la figure 8 représente la sélectivité d'un circuit récupérateur de fréquence faisant partie d'un dispositif de synthèse de fréquence, objet de la présente invention,
- les figures 9A et 9B représentent des formes d'ondes et des spectres des signaux générés dans un dispositif de synthèse de fréquence, objet de la présente invention,
- la figure 10 représente le spectre d'un signal $S_G$ généré dans un dispositif de synthèse de fréquence, objet de la présente invention, selon un exemple de réalisation,
- la figure 11 représente le spectre d'un signal $S_2$ obtenu en sortie d'un dispositif de synthèse de fréquence, objet de la présente invention, selon un exemple de réalisation,
- la figure 12 représente le bruit de phase d'un signal $S_2$ obtenu en sortie d'un dispositif de synthèse de fréquence, objet de la présente invention, selon un exemple de réalisation,
- la figure 13 représente schématiquement un système de communication, également objet de la présente invention, comportant un dispositif de synthèse de fréquence selon l'invention ;
- les figures 14A et 14B représentent de signaux S2 obtenus en sortie d'un dispositif de synthèse de fréquence, objet de la présente invention, selon un exemple de réalisation ;
- la figure 15 représente schématiquement un dispositif de synthèse de fréquence, objet de la présente invention, selon un deuxième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

On se réfère tout d'abord à la figure 4 qui représente un dispositif de synthèse de fréquence 100 selon un premier mode de réalisation.

Le dispositif 100 comporte un oscillateur 102 par exemple de type VCO fournissant en sortie un signal périodique $S_1$ de fréquence $f_1$, par exemple sinusoïdal de fréquence d'oscillation $f_1$. La fréquence $f_1$ est contrôlée par une tension appliquée sur une entrée de commande 104 de l'oscillateur 102. Afin de verrouiller et stabiliser la fréquence d'oscillation $f_1$ du signal $S_1$, l'oscillateur 102 est asservi par une boucle de verrouillage de phase (PLL). Cette PLL comporte un ou plusieurs diviseurs de fréquence 106 aptes à diviser la fréquence du signal $S_1$ par un nombre $A$ entier ou fractionnaire. On obtient en sortie du ou des diviseurs de fréquence 106 un signal périodique de fréquence $f_1/A$ qui est ensuite comparé à un signal périodique de référence très stable de fréquence $f_{stable}$ fourni par un résonateur 108, par exemple à quartz. Le facteur $A$ est choisi tel que la fréquence $f_1/A$ soit proche de la fréquence $f_{stable}$. Une comparaison entre ces deux signaux est réalisée par un comparateur de phases 110 (PFD) générant un signal de sortie proportionnel à la différence de phases mesurée entre ces deux signaux, dont la valeur est positive ou négative selon le signe de la différence $f_1/A - f_{stable}$.

Ce signal de sortie est envoyé en entrée d'un circuit de pompe de charge et d'un filtre 112 délivrant en sortie le signal appliqué sur l'entrée de commande 104 de l'oscillateur 102 afin d'ajuster la fréquence d'oscillation $f_1$, de sorte

à ce que $f_1/A = f_{stable}$.

Les éléments 102, 106, 108, 110 et 112 permettent d'obtenir un signal périodique $S_1$, par exemple sinusoïdal, qui soit stable en fréquence. En variante, il est possible de remplacer ces éléments 102, 106, 108, 110 et 112 par n'importe quel dispositif ou structure apte à fournir un tel signal périodique $S_1$ stable en fréquence, correspondant par exemple à un seul dispositif résonateur lorsqu'un tel dispositif résonateur peut fournir directement le signal $S_1$. Le choix du type de dispositif ou structure générant le signal périodique $S_1$ peut notamment être fait en fonction de la fréquence $f_1$ souhaitée. Un dispositif résonateur seul peut être suffisant si la fréquence $f_1$ ne dépasse pas une valeur au-delà de laquelle il peut alors être nécessaire de faire appel à une PLL pour générer le signal $S_1$.

Le dispositif de synthèse de fréquence 100 comporte en outre un générateur de train d'oscillations répétées périodiquement (appelé par la suite « TORP ») dans la bande de fréquences à synthétiser et un récupérateur de fréquence.

Dans ce premier mode de réalisation, le générateur de TORP est composé d'un oscillateur 114 de type VCO contrôlé en tension par un signal de contrôle $V_{ctrl}$, et des moyens d'alimentation électrique commandés 116 alimentant électriquement l'oscillateur 114 et qui sont commandés par le signal $S_1$ de fréquence $f_1$ délivré par l'oscillateur 102. Sur l'exemple de la figure 4, cette alimentation électrique commandée correspond à une source de courant commandée 116 fonctionnant comme un interrupteur interrompant périodiquement (période $T_1 = 1/f_1$) l'alimentation électrique de l'oscillateur 114. Cette source de courant commandée peut correspondre à un transistor MOS comportant une grille sur laquelle est appliqué le signal $S_1$. De manière générale, ces moyens 116 peuvent comporter un interrupteur relié à une entrée d'alimentation électrique de l'oscillateur 114 et apte à être commandé par le signal périodique $S_1$.

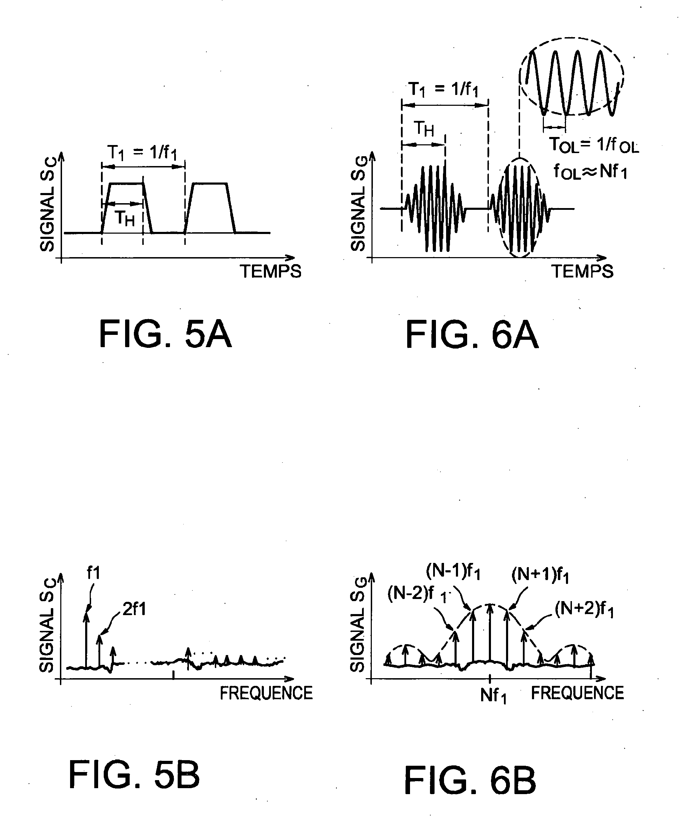

L'oscillateur 114 est donc commuté par cet interrupteur mettant alternativement l'oscillateur 114 en état ON et en état OFF, c'est-à-dire interrompant ou non la fourniture d'un signal de sortie par l'oscillateur 114, successivement à la fréquence $f_1$. L'oscillateur 114 est commandé par un signal $S_C$ correspondant au courant généré par la source de courant 116 (et donc à la tension d'alimentation fournie à l'oscillateur 114) et dont la forme d'onde correspond sensiblement à un signal carré positif de fréquence $f_1$ (ce signal carré n'est pas parfait et peut présenter une forme trapézoïdale, comme c'est le cas du signal $S_C$ représenté sur la figure 5A). Ainsi, lorsque le signal de commutation $S_C$ met l'oscillateur 114 en marche, un signal $S_G$ correspondant à un train d'oscillations est créé à la sortie du VCO. Une demi-période $T_1/2$ (avec $T_1 = 1/f_1$) plus tard, l'oscillateur 114 est éteint et l'oscillation est interrompue. L'alternance de l'état ON et de l'état OFF toutes les demi-périodes $T_1/2$ correspond au cas où le signal $S_C$ présente un rapport cyclique égal à 0,5. Le signal $S_C$ représenté sur la figure 5A allume l'oscillateur 114 pendant une durée $T_H$ qui est égale, dans cet exemple, à $T_1/2$.

Toutefois, ce rapport cyclique (égal à $T_H/T_1$) peut être différent de 0,5, et plus généralement compris entre 0 et 1, les valeurs 0 et 1 étant exclues, la durée de l'état ON pouvant être supérieure ou inférieure à celle de l'état OFF.

Ainsi, un signal pulsé $S_G$ est créé à une fréquence centrale $f_{OL}$, correspondant à la fréquence d'oscillation libre de l'oscillateur 114, avec une période de répétition égale à $T_1$. Le signal $S_G$ correspond donc à un TORP, c'est-à-dire ici un train d'oscillations de fréquence $f_{OL}$, de durée inférieure à $T_1 = 1/f_1$ et répété périodiquement avec une période de répétition égale à $T_1$. Le signal $S_G$ a donc périodiquement une valeur nulle sur une partie de chaque période $T_1$, cette partie de chaque période $T_1$ correspondant approximativement à la partie de chaque période $T_1$ au cours de laquelle le signal $S_C$ a une valeur nulle. Le signal $S_G$ a la particularité d'avoir sa phase verrouillée sur celle du signal de fréquence $f_1$ fourni par l'oscillateur 102 et a une fréquence centrale $f_{OL}$ qui est sensiblement égale à un multiple entier de $f_1$ ($f_{OL} \approx N.f_1$). Cette propriété est due au fait qu'au démarrage de l'oscillation, l'oscillateur 114 présente une élasticité élevée et se verrouille facilement sur une harmonique $N$ de la fréquence $f_1$ avec $N$ tel que le produit $N \cdot f_1$ soit le plus proche de la fréquence d'oscillation libre $f_{OL}$ de l'oscillateur 114 lorsqu'il se trouve en oscillation libre. La valeur de $N$, et donc celle de la fréquence $f_{OL}$, dépendent de la valeur de la tension $V_{ctrl}$ appliquée en entrée de l'oscillateur 114.

Le spectre équivalent du signal $S_G$ présente une enveloppe dont la forme correspond à un sinus cardinal dont les composantes sont des sinusoïdes de fréquence centrale $N.f_1$. Les raies du spectre de $S_G$ sont espacées les unes des autres de $f_1$. Les figures 5A et 5B représentent respectivement la forme d'onde (domaine temporel) et le spectre (domaine fréquentiel) du signal $Sc$. De même, les figures 6A et 6B représentent respectivement la forme d'onde et le spectre du signal $S_G$. Sur la figure 6A, on voit que dans chaque train d'oscillations du signal $S_G$, les amplitudes des oscillations sont croissantes lors du démarrage de l'oscillateur 114 et sont décroissantes lors de l'arrêt de l'oscillateur 114. De plus, les oscillations des trains d'oscillations de $S_G$ sont similaires, en termes de phase, d'amplitude et de fréquence, d'un train à l'autre.

D'un point de vue analytique, le signal $S_G$ est obtenu par la convolution dans le domaine temporel entre un sinus fenêtré, de fréquence $f_{OL}$ (correspondant à la fréquence d'oscillation libre de l'oscillateur 114) et de largeur de fenêtre égale à $T_H$, avec $T_H \in ]0, T_1[$, et un peigne de Dirac de période égale à $T_1$. Le signal $S_G$ peut donc s'exprimer sous la forme :

$$S_G(t) = \left[sin(2 \cdot \pi \cdot f_{OL} \cdot t) \cdot \Pi_{T_H}(t)\right] \otimes \sum_{k=-\infty}^{\infty} \delta(t - k \cdot T_1)$$

$\Pi_{T_H}(t)$ est la fonction de fenêtrage correspondant à :

$$\Pi_{T_H}(t) = \begin{cases} 0 & \forall\, t < 0 \\ 1 & \forall\, t \in\; ]0, T_1[ \\ 0 & \forall\, t > T_H \end{cases}$$

Le spectre fréquentiel du signal $S_G$ correspond dans ce cas à :

$$\left| S_G(f) \right|_{f>0} = \left[ \frac{1}{2}\delta(f - f_{OL}) \otimes T_H \cdot sinc(\pi \cdot f \cdot T_H) \right] \cdot f_1 \cdot \sum_{k=-\infty}^{\infty} \delta(f - k \cdot f_1)$$

Pour chacune des raies de fréquences $f_i$ du spectre du signal $S_G$ ($f_i$ étant des multiples de $f_1$), l'amplitude $A_i$ de chacune de ces raies peut être exprimée par l'équation :

$$A_i = \frac{1}{2} sin\, c\left(\pi(f_i - f_{OL}).T_H\right)$$

Le signal $S_G$ est ensuite utilisé pour obtenir en sortie du dispositif 100 un signal $S_2$ périodique, par exemple sinusoïdal, dont le spectre fréquentiel comporte une raie, ou pic, principale, c'est-à-dire de plus forte valeur par rapport aux autres raies, de fréquence $f_2$ correspondant à la fréquence à synthétiser par le dispositif 100. Aussi, afin d'obtenir un spectre correspondant, ou s'approchant, d'un sinus pur sans les raies adjacentes (correspondant aux raies à $(N+x).f_1$, avec x nombre entier, sur le spectre du signal $S_G$ représenté sur la figure 6B, lorsque $f_2 = f_{OL}$), le dispositif 100 comporte un circuit de récupération de fréquence 118, ou circuit de récupération de raie, dont l'entrée est reliée à la sortie de l'oscillateur pulsé 114. Le circuit récupérateur de fréquence 118 joue le rôle de filtre passe-bande et rejette les raies adjacentes à la fréquence à récupérer. On obtient, à la sortie du circuit récupérateur de fréquence 118, un signal $S_2$ périodique dont la raie principale a pour fréquence $N \cdot f_1$ lorsque $f_2 = f_{OL}$, par exemple un signal sinusoïdal avec une enveloppe sensiblement constante dont la fréquence $f_2$ est par exemple égale à $N \cdot f_1$, Le bruit de phase du signal $S_2$ est égal au bruit de phase du signal $S_1$ plus 20log($N$), ou N est le facteur de multiplication entre $f_1$ et $f_2$:

$$PhN^{f_2}_{dBc/Hz} = PhN^{f_1}_{dBc/Hz} + 20log(N)$$

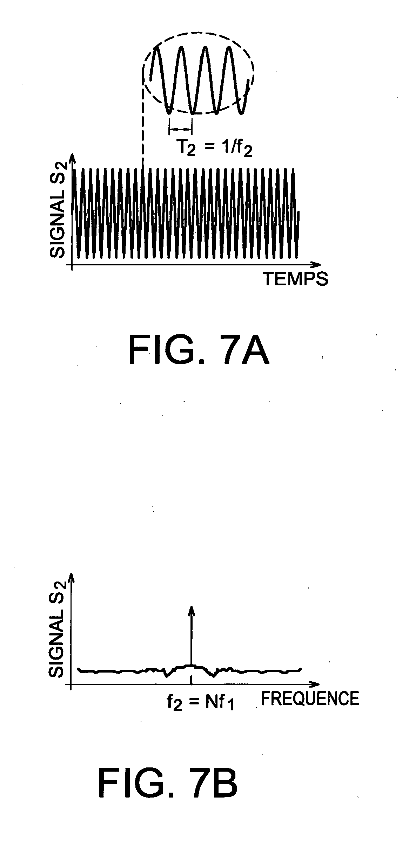

Les figures 7A et 7B représentent respectivement la forme d'onde (domaine temporel) et le spectre (domaine fréquentiel) du signal $S_2$. Ainsi, on obtient en sortie du dispositif 100 un signal $S_2$ de spectre pur, c'est-à-dire comportant une unique raie à la fréquence $f_2$ verrouillée sur $f_{stable}$, toutes les autres composantes non désirées ayant été rejetées par le circuit récupérateur de fréquence 118.

Les oscillateurs 102 et 114 sont par exemple réalisés sous la forme de paires croisées différentielles (résonateurs couplés avec une résistance négative). L'oscillateur 114 peut par exemple être réalisé comme décrit dans le document « A 60 GHz UWB impulse radio transmitter with integrated antenna in CMOS65nm SOI technology » de A. Siligaris et al., Silicon Monolithic Integrated Circuits in RF Systems (SiRF), 2011 IEEE 11th Topical Meeting on, pp. 153-156, 17-19 Jan. 2011. L'oscillateur 102 peut par exemple être réalisé comme décrit dans le document « A 17.5-to-20.94GHz and 35-to-41.88GHz PLL in 65nm CMOS for wireless HD applications » de O. Richard et al., Solid-State Circuits Conférence Digest of Technical Papers (ISSCC), 2010 IEEE International, pp.252-253, 7-11 Feb. 2010.

Le circuit récupérateur de fréquence 118 joue un rôle de filtre passe-bande de très haute sélectivité, et peut correspondre à un circuit oscillateur verrouillé, ou synchronisé, par injection (ILO) ou plusieurs circuits ILO disposés en cascade. La réalisation d'un tel ILO est par exemple décrite dans le document « A 50 GHz direct injection locked oscillator topology as low power frequency divider in 0.13 $\mu$m CMOS » de M. Tiebout, Solid-State Circuits Conference, 2003. ESSCIRC '03. Proceedings of the 29th European, pp. 73- 76, 16-18 Sept. 2003.

Un tel circuit oscillateur fonctionne en continu et en l'absence de signal $S_G$ appliqué en entrée (lorsque le signal $S_G$ a périodiquement une valeur nulle), le circuit 118 délivre en sortie un signal sinusoïdal d'oscillation libre dont la fréquence $f_{osc\_libre\_118}$ est dans la même bande de fréquence que $f_2$ ($f_{osc\_libre\_118} \approx f_2$). La valeur de la fréquence $f_{osc\_libre\_118}$ dépend uniquement de la valeur d'un signal de contrôle $V_{ctrl\_118}$ appliqué sur une autre entrée du circuit récupérateur de fréquence 118. Lorsque sa première entrée est excitée par le signal $S_G$ pulsé délivré par l'oscillateur 114, le circuit récupérateur de fréquence 118 se verrouille à la raie du signal $S_G$ la plus proche de $f_{osc\_libre\_118}$. Le signal de contrôle $V_{ctrl\_118}$ permet de positionner $f_{osc\_libre\_118}$ proche de $N \cdot f_1$ afin de centrer le signal $S_2$ exactement sur $N \cdot f_1$, c'est-à-dire $f_G$, ou sur une raie adjacente de $N \cdot f_1$. Il est donc possible de verrouiller le circuit récupérateur de fréquence 118 sur une raie $(N+i) \cdot f_1$, avec i nombre entier (positif ou négatif ou nul), si le signal de contrôle $V_{ctrl\_118}$ est tel que $f_{osc\_libre\_118}$ se situe proche de la raie $(N+i) \cdot f_1$.

La fréquence $f_2$ synthétisable par le dispositif 100 est donc paramétrable et égale à :

$$f_2 = \left(N + i\right) \cdot f_1$$

La programmation, ou le réglage, de la valeur de la fréquence $f_2$ synthétisée s'effectue donc via les paramètres $N$ et/ou i et/ou $f_1$.

Les paramètres $N$ et i peuvent être modifiés via la valeur du signal de contrôle $V_{ctrl}$ de l'oscillateur 114 d'une part, et la valeur du signal de contrôle $V_{ctrl\_118}$ du circuit récupérateur de fréquence 118 d'autre part.

Une première possibilité de programmation de la valeur de la fréquence $f_2$ consiste à verrouiller l'oscillateur 114 directement sur la fréquence désirée en sortie tel que $f_{OL} = f_2 = N.f_1$. En effet, comme expliqué précédemment, au démarrage de l'oscillation, l'oscillateur 114 présente une élasticité élevée et a tendance à se verrouiller facilement sur une harmonique N de la fréquence $f_1$. La valeur de la fréquence d'oscillation de l'oscillateur 114 $f_{OL}$ est donc fixée en réglant la valeur de $V_{ctrl}$ telle que $f_{OL} = f_2 = N \cdot f_1$. La fréquence centrale $f_{OL}$ du spectre de l'oscillateur 114 se verrouille alors sur la raie $N.f_1$. Le circuit récupérateur de fréquence 118 voit alors à son entrée un signal $S_G$ dont le spectre est un sinus cardinal de raies espacées de $f_1$ dont la raie centrale se trouve à $f_{OL} = N.f_1$. Le signal de contrôle $V_{ctrl\_118}$ du circuit récupérateur de fréquence 118 est choisi pour que le verrouillage ait lieu sur la raie centrale, à la fréquence $f_{OL}$, c'est-à-dire avec i = 0. Ainsi, dans cette première programmation possible de la valeur de $f_2$, la valeur de la fréquence synthétisée $f_2$ est choisie via le choix de la valeur du signal de contrôle $V_{ctrl}$ de l'oscillateur 114 (déterminant la valeur de N), la valeur du signal de contrôle $V_{ctrl\_118}$ du circuit récupérateur de fréquence 118 étant constante et choisie telle que i = 0).

Une deuxième possibilité pour régler la valeur de $f_2$ consiste à verrouiller l'oscillateur 114 sur une fréquence $f_{OL} = N.f_1$ avec N fixe (c'est-à-dire $V_{ctrl}$ de valeur constante). Le spectre du signal de sortie $S_G$ est un sinus cardinal de raies espacées de $f_1$ dont la raie centrale est à la fréquence $f_{OL}$. Le signal de contrôle $V_{ctrl\_118}$ du circuit récupérateur de fréquence est ensuite choisi pour que le verrouillage ait lieu sur une des raies adjacentes à la raie centrale $f_{OL}$ correspondant à la fréquence $f_2$ recherchée (c'est-à-dire tel que $i \neq 0$), dans le lobe principal du spectre en sinus cardinal. Dans ce deuxième exemple de programmation, la valeur de la fréquence synthétisée $f_2$ est choisie via le choix de la valeur du signal de contrôle $V_{ctrl\_118}$ du circuit récupérateur de fréquence 118 (déterminant la valeur de i qui est différente de 0), la valeur du signal de contrôle $V_{ctrl}$ de l'oscillateur 114 étant constante et choisie pour que la valeur de N soit telle que la raie de fréquence $f_2$ se situe dans le lobe principal du spectre en sinus cardinal de raie centrale à la fréquence $f_{OL}$ telle que $f_{OL} = N.f_1$).

Dans une troisième possibilité de programmation de la valeur de $f_2$, il est possible de combiner les deux possibilités précédentes. Il s'agit alors de jouer à la fois sur le signal de contrôle $V_{ctrl}$ de l'oscillateur 114 (jouant sur la valeur de N) et sur le signal de contrôle $V_{ctrl\_118}$ du circuit récupérateur de fréquence 118 (jouant sur la valeur de i) pour synthétiser la fréquence $f_2$ souhaitée.

Quelque soit la possibilité de programmation choisie parmi celles exposées précédemment, la valeur de $f_2$ peut également être modifiée via le réglage ou le choix de la valeur de la fréquence $f_1$ étant donné que la valeur de $f_1$ correspond à l'espacement des raies dans le spectre du signal $S_G$.

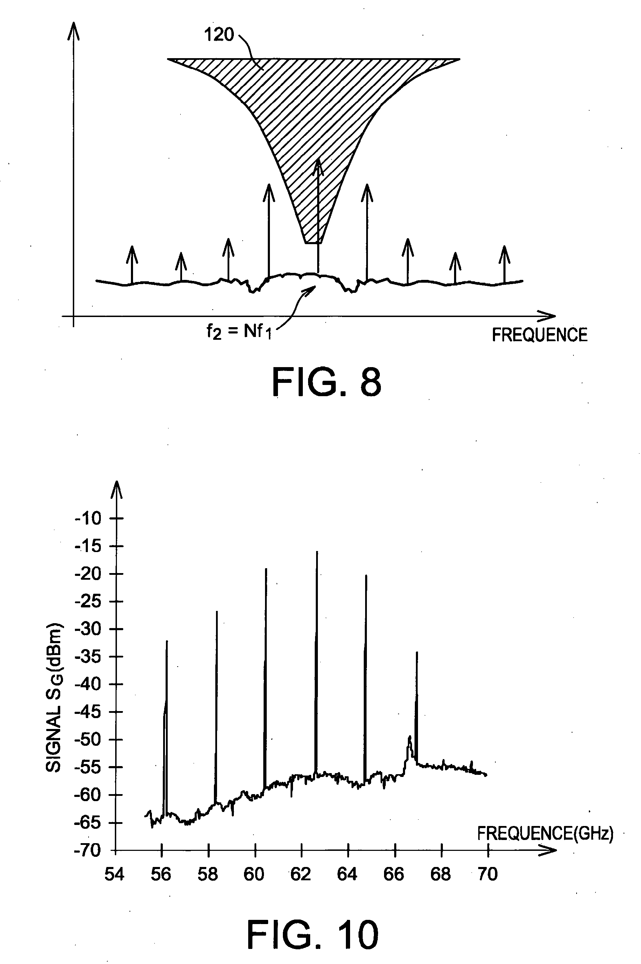

Le circuit récupérateur de fréquence 118 permet de sélectionner une raie située dans le lobe principal du spectre du signal $S_G$ délivré par l'oscillateur 114. Il agit à la fois comme un filtre passe-bande très sélectif et comme un régénérateur de signal, par le biais du verrouillage réalisé sur la fréquence $(N+i)f_1$. La sélectivité du circuit récupérateur de fréquence 118, lorsque celui-ci correspond à un circuit de type oscillateur verrouillé par injection (ILO), est représenté sur la figure 8. La zone référencée 120 représente la plage de verrouillage d'un tel ILO qui, sur l'exemple de la figure 8, se verrouille sur la raie centrale du spectre du signal $S_G$ qui est la plus proche de sa fréquence d'oscillation libre.

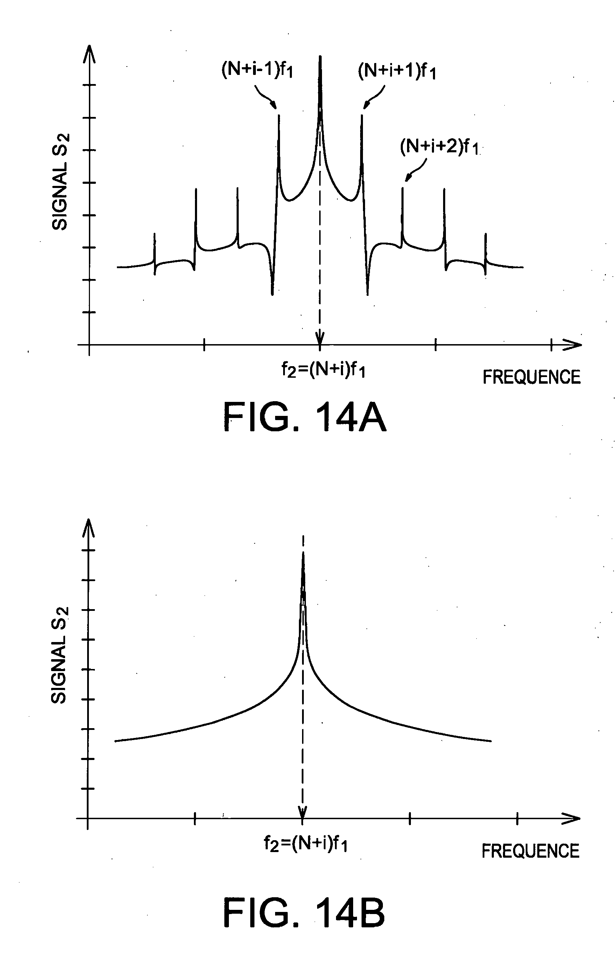

Le signal de sortie de cet ILO est composé principalement de cette raie mais la réjection des raies adjacentes n'est pas infinie. Ainsi, le signal $S_2$ obtenu en sortie du circuit récupérateur de fréquence 118 peut correspondre non pas à un signal sinusoïdal pur, mais à un signal périodique dont l'enveloppe n'est jamais nulle (contrairement au signal $S_G$ dont l'enveloppe est périodiquement nulle) et dont le spectre fréquentiel présente une raie principale à la fréquence $f_2$. Les raies secondaires de ce spectre, à des fréquences multiples de $f_1$, sont atténuées par rapport aux raies secondaires du spectre du signal $S_G$. La figure 14A représente un spectre d'un signal $S_2$ obtenu par exemple avec un circuit récupérateur de fréquence 118 comprenant un seul ILO. Il est possible d'augmenter cette réjection en reliant en cascade (c'est-à-dire en série) un ou plusieurs autres ILO pour former le circuit récupérateur de fréquence 118 et atténuer ainsi encore plus les raies secondaires du spectre du signal $S_2$, ce qui permet d'améliorer la constance de l'enveloppe du signal $S_2$. La figure 14B représente un spectre d'un signal $S_2$ obtenu par exemple avec un circuit récupérateur de fréquence 118 comprenant plusieurs ILO reliés en cascade. On voit sur cette figure que le signal $S_2$ correspond donc quasiment à un signal sinusoïdal pur.

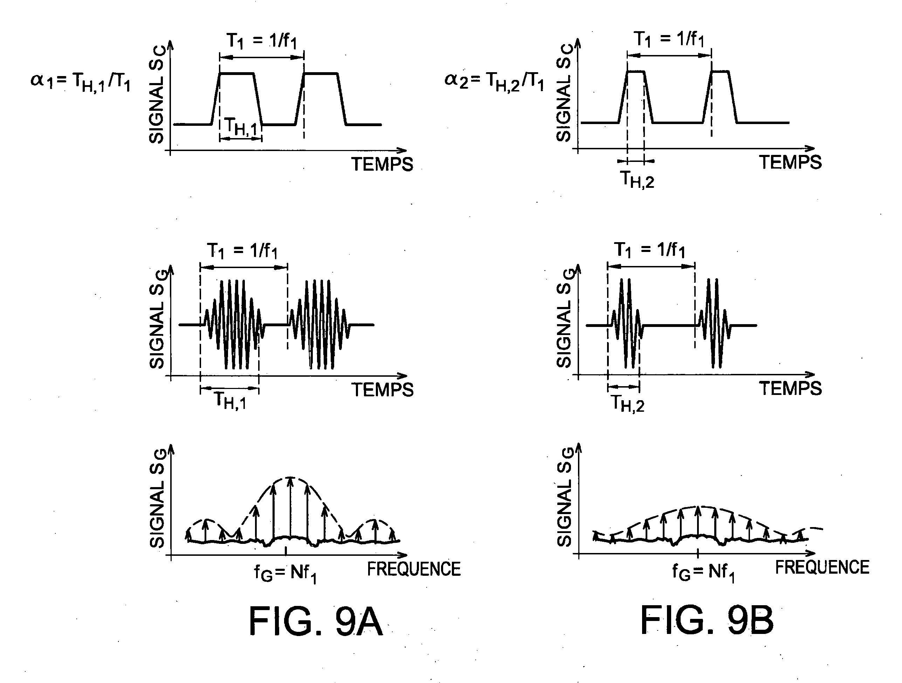

Concernant la forme du spectre du signal $S_G$, plus le rapport cyclique de ce signal est faible, plus le premier lobe du sinus cardinal est large. Ainsi, un petit rapport cyclique implique la présence d'un plus grand nombre de raies dans le lobe principal du spectre du signal $S_G$, et donc plus de fréquences potentiellement synthétisables en faisant varier i pour un $N$ donné. Ce principe est illustré sur les figures 9A et 9B qui représentent les formes d'ondes des signaux $S_C$ et $S_G$, et le spectre du signal $S_G$, pour deux signaux $S_C$ de rapports cycliques $\alpha_1$ (=$T_{H1}/T_1$) et $\alpha_2$ (=$T_{H2}/T_1$) différents, le rapport cyclique $\alpha_1$ du signal $S_C$ représenté sur la figure 9A étant supérieure au rapport cyclique $\alpha_2$ du signal $S_C$ représenté sur la figure 9B.

En variante, le circuit récupérateur de fréquence 118 peut correspondre à un ou plusieurs filtres passe-bande reliés en cascade. Ce ou ces filtres sont réalisés tels que leur fréquence centrale soit proche de la raie du signal $S_G$ de fréquence $(N+i).f_1$, ce qui permet de filtrer le signal $S_G$ et récupérer la raie de fréquence $(N+i).f_1$ correspondant à la fréquence $f_2$ souhaitée. Ce ou ces filtres sont également réalisés tels qu'ils soient très sélectifs. Ce ou ces filtres peuvent être réalisés de plusieurs façons, par exemple sous la forme de filtre BAW (à ondes acoustiques de volume), LC (à partir d'inductances et de capacités) ou encore de filtre SAW (à ondes acoustiques de surface). De plus, il est également possible que le circuit récupérateur de fréquence 118 comporte un ou plusieurs ILO et un ou plusieurs filtres passe-bande reliés en cascade.

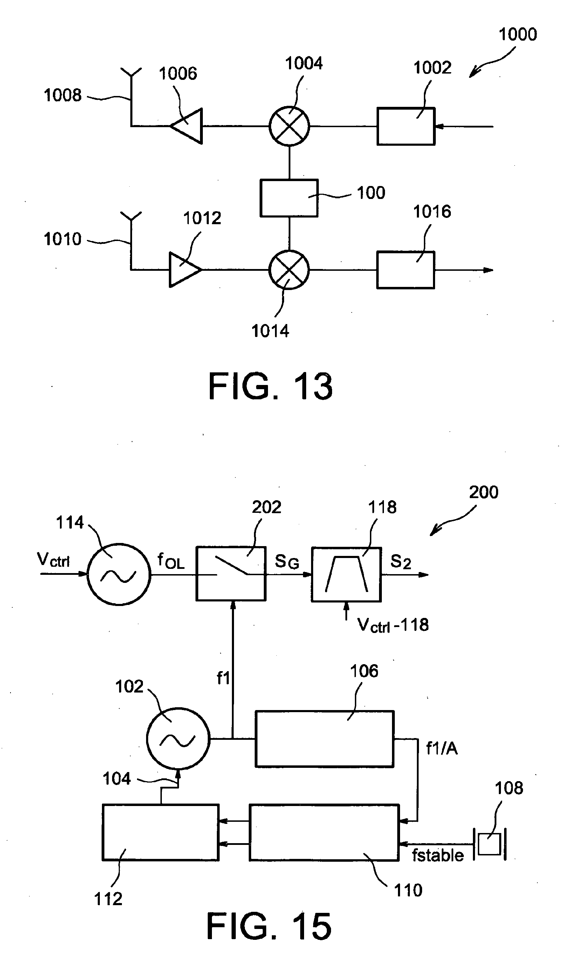

On se réfère à la figure 15 qui représente un dispositif de synthèse de fréquence 200 selon un deuxième mode de réalisation.

Par rapport au dispositif 100 précédemment décrit, l'oscillateur 114 n'est plus commandé par une source d'alimentation interrompue périodiquement, mais est alimenté en continu, fournissant un signal sinusoïdal de fréquence $f_{OL}$. Ce signal est envoyé en entrée d'un interrupteur 202 commandé par le signal périodique $S_1$. L'interrupteur 202 est périodiquement (période $T_1$) en position fermée pendant une durée égale à $T_H$ (par exemple égale à $T_1/2$ dans le cas d'un rapport cyclique de 0,5) et en position ouverte pendant une durée égale à $T_1 - T_H$.

On obtient dans ce cas, en entrée du circuit 118, un signal $S_G$ de type TORP, c'est-à-dire de type train d'oscillations de fréquence $f_{OL}$ répété périodiquement avec une période de répétition égale à $T_1$. Les oscillations des trains d'oscillations de $S_G$ ne sont généralement pas similaires, en termes de phase, d'un train à l'autre.

D'un point de vue analytique, ce signal $S_G$ correspond au produit d'un sinus de fréquence $f_{OL}$ (la fréquence d'oscillation libre de l'oscillateur 114) et d'un signal carré périodique de période $T_1$ et d'une durée à l'état haut $T_H$ avec $T_H \in ]0,T_1[$ tel que :

$$S_G(t) = sin(2 \cdot \pi \cdot f_{OL} \cdot t) \cdot \left[ \Pi_{T_H}(t) \otimes \sum_{k=-\infty}^{\infty} \delta(t - k \cdot T_1) \right]$$

Le spectre fréquentiel du signal $S_G$ correspond dans ce cas à :

$$\left| S_G(f) \right|_{f>0} = \frac{1}{2} \delta(f - f_{OL}) \otimes \left[ T_H \cdot \text{sinc}(\pi \cdot f \cdot T_H) \cdot f_1 \cdot \sum_{k=-\infty}^{\infty} \delta(f - k \cdot f_1) \right]$$

Pour chacune des raies de fréquences $f_i$ du spectre du signal $S_G$ (avec $f_i = f_{OL} + i.f_1$), l'amplitude $A_i$ de chacune de ces raies peut être exprimée par l'équation :

$$A_i = \frac{T_H}{2.T_1} \, sin\,c\left(\pi.i\,\frac{T_H}{T_1}\right)$$

Les différentes variantes de réalisation du circuit récupérateur de fréquence 118 précédemment décrites pour le dispositif de synthèse de fréquence 100 peuvent s'appliquer également au dispositif de synthèse de fréquence 200.

On décrit ci-dessous un exemple de réalisation du dispositif de synthèse de fréquence 100.

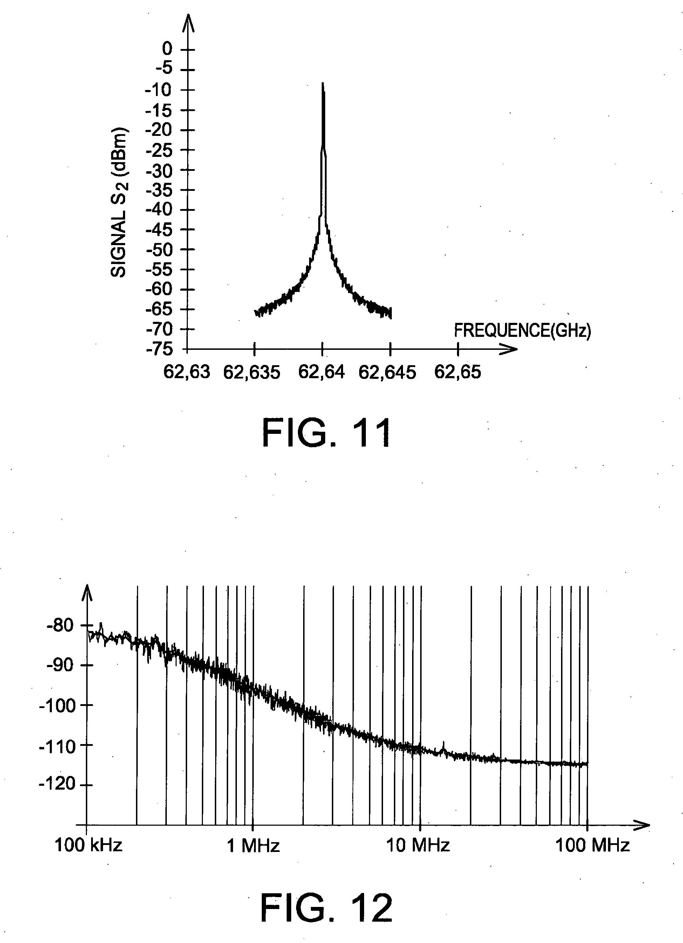

La PLL fournissant le signal $S_1$, la source de courant 116 et l'oscillateur 114 ainsi que le circuit récupérateur de fréquence 118 sont réalisés par exemple en technologie CMOS 65 nm par exemple sur SOI afin d'obtenir par exemple un dispositif de synthèse de fréquence conforme à la norme IEEE.802.15.3c relative aux réseaux WPAN, WirelessHD ou WiGig, dans lesquels les transmissions de signaux sont par exemple réalisées dans une gamme de fréquences comprise entre environ 57 GHz et 66 GHz. Les éléments 102, 106, 108, 110 et 112 sont réalisés afin d'obtenir en sortie de l'oscillateur 102 un signal $S_1$ de fréquence $f_1$ égale à environ 2,16 GHz avec un signal de référence $f_{stable}$ = 36 MHz. L'oscillateur 114 est par exemple réalisé afin de délivrer en sortie un signal $S_G$ dont le spectre est représenté sur la figure 10. On voit sur ce spectre que les différentes raies, représentant différents canaux de communication possibles selon les normes de communication, sont bien espacées de $f_1$ les unes des autres. Les tensions de commande $V_{ctrl}$ et $V_{ctrl\_118}$ sont choisies telles que le circuit récupérateur de fréquence 118 délivre un signal $S_2$ de fréquence $f_2$ = 62,64 GHz (canal 3 des normes). Le spectre du signal S2 obtenu en sortie d'un tel dispositif de synthèse de fréquence 100 est représenté sur la figure 11. Enfin, le bruit de phase de ce signal $S_2$ est représenté sur la figure 12. Ceci s'applique également pour la réalisation du dispositif de synthèse de fréquence 200.

Le dispositif de synthèse de fréquence 100 ou 200 est par exemple utilisé dans un système de transmission RF 1000 dans un exemple d'architecture est représenté de manière schématique sur la figure 13. Le système de transmission 1000 comporte des éléments servant à réaliser une émission de signaux tels qu'un circuit de traitement en bande de base 1002 recevant en entrée l'information à émettre, un modulateur 1004, un amplificateur de puissance 1006 et une antenne d'émission 1008. Le dispositif de synthèse de fréquence 100 ou 200 est utilisé conjointement avec le modulateur 1004 afin de moduler le signal à la fréquence porteuse souhaitée (fréquence $f_2$), par exemple une fréquence RF de l'ordre d'un ou plusieurs GHz. Le système de transmission 1000 comporte également des éléments servant à réaliser une réception de signaux : un circuit de traitement qu'une antenne de réception 1010, un amplificateur faible bruit 1012, un démodulateur 1014 et un circuit de traitement en bande de base 1016. Le dispositif de synthèse de fréquence 100 est utilisé conjointement avec le démodulateur 1014 afin de démoduler le signal RF reçu en bande de base.

## Revendications

1. Dispositif de synthèse de fréquence (100, 200), comportant au moins :

   - des premiers moyens (102, 104, 106, 108, 110, 112) aptes à générer un signal périodique de fréquence $f_1$,
   - des deuxièmes et troisièmes moyens (114, 116, 202), couplés aux premiers moyens (102, 104, 106, 108, 110, 112) et aptes à recevoir en entrée le signal périodique de fréquence $f_1$ et à générer un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
   - des quatrièmes moyens (118) aptes à générer, à partir du signal $S_G$, un signal périodique dont le spectre fréquentiel comporte une raie principale de fréquence $f_2 = (N+i).f_1$, avec i nombre entier, en jouant un rôle de filtre passe-bande appliqué sur le signal $S_G$ et rejetant du spectre fréquentiel dudit signal périodique les raies autres que la raie principale dudit signal périodique.

2. Dispositif de synthèse de fréquence (100, 200) selon la revendication 1, dans lequel le signal périodique dont le spectre fréquentiel comporte la raie principale de fréquence $f_2$ est un signal sensiblement sinusoïdal présentant une enveloppe sensiblement constante.

3. Dispositif de synthèse de fréquence (100, 200) selon l'une des revendications précédentes, dans lequel les deuxièmes moyens (114) comportent au moins un oscillateur commandé en tension dont la plage d'oscillation libre inclut la fréquence $N.f_1$, la valeur de $N$ étant fonction d'une valeur d'une première tension de commande destinée à être appliquée en entrée de l'oscillateur commandé en tension.

4. Dispositif de synthèse de fréquence (100) selon la revendication 3, dans lequel les troisièmes moyens (116) comportent au moins un interrupteur relié à une entrée d'alimentation électrique de l'oscillateur (114) et apte à être commandé par le signal périodique de fréquence $f_1$ tel qu'il génère une tension d'alimentation de l'oscillateur (114) non nulle seulement pendant une partie de chaque période $T_1$.

5. Dispositif de synthèse de fréquence (200) selon la revendication 3, dans lequel les troisièmes moyens (202) comportent au moins un interrupteur relié à une sortie de l'oscillateur (114) et apte à être commandé par le signal périodique de fréquence $f_1$ tel qu'il coupe une liaison électrique entre la sortie de l'oscillateur (114) et l'entrée des quatrièmes moyens (118) pendant une partie de chaque période $T_1$.

6. Dispositif de synthèse de fréquence (100, 200) selon l'une des revendications précédentes, dans lequel les quatrièmes moyens (118) comportent au moins un oscillateur verrouillé par injection destiné à recevoir en entrée le signal $S_G$ et à être verrouillé au moins périodiquement à la fréquence $f_2$, la valeur de $i$ étant fonction d'une valeur d'une deuxième tension de commande destinée à être appliquée en entrée de l'oscillateur verrouillé par injection.

7. Dispositif de synthèse de fréquence (100, 200) selon l'une des revendications précédentes, dans lequel les quatrièmes moyens (118) comportent au moins un filtre passe-bande de fréquence centrale sensiblement égale à $f_2$.

8. Dispositif de synthèse de fréquence (100, 200) selon l'une des revendications précédentes, dans lequel la valeur de la fréquence $f_1$ est supérieure à environ 1 GHz, et/ou la valeur de la fréquence $f_2$ est supérieure à environ 10 GHz, et/ou les oscillations du signal $S_G$ sont sinusoïdales.

9. Dispositif de synthèse de fréquence (100, 200) selon l'une des revendications précédentes, dans lequel les premiers moyens comportent au moins un dispositif résonateur (108) et une boucle à verrouillage de phase (102, 104, 106, 110, 112) apte à asservir la phase du signal périodique de fréquence $f_1$ délivré par un oscillateur commandé en tension (102) de la boucle à verrouillage de phase sur une phase d'un signal périodique délivré par le dispositif résonateur (108).

10. Dispositif de synthèse de fréquence (100, 200) selon l'une des revendications 1 à 8, dans lequel les premiers moyens comportent un dispositif résonateur apte à générer le signal périodique de fréquence $f_1$.

11. Dispositif d'émission et/ou de réception de signaux (1000), comportant au moins un dispositif de synthèse de fréquence (100, 200) selon l'une des revendications précédentes couplé à un modulateur (1004) et/ou un démodulateur (1014) du dispositif d'émission et/ou de réception (1000).

12. Procédé de synthèse de fréquence, comportant au moins les étapes de :

- génération d'un signal périodique de fréquence $f_1$,
- génération, à partir du signal périodique de fréquence $f_1$, d'un signal $S_G$ correspondant à un train d'oscillations de fréquence sensiblement égale à $N.f_1$, de durée inférieure à $T_1 = 1/f_1$ et répété périodiquement à la fréquence $f_1$, avec N nombre entier supérieur à 1,
- génération, à partir du signal $S_G$, d'un signal périodique dont le spectre fréquentiel comporte une raie principale de fréquence $f_2 = (N+i).f_1$, avec $i$ nombre entier, via la mise en oeuvre d'une fonction de filtrage passe-bande appliquée sur le signal $S_G$ et rejetant du spectre fréquentiel dudit signal périodique les raies autres que la raie principale dudit signal périodique.

13. Procédé de réalisation d'un dispositif de synthèse de fréquence (100, 200), comportant au moins les étapes de :

- réalisation de premiers moyens (102, 104, 106, 108, 110, 112) aptes à générer un signal périodique de fréquence $f_1$,
- réalisation de deuxièmes et troisièmes moyens (114, 116, 202), couplés aux premiers moyens (102, 104, 106, 108, 110, 112) et aptes à recevoir en entrée le signal périodique de fréquence $f_1$ et à générer un signal $S_G$ correspondant à un train d'oscillations de fréquence sensiblement égale à $N.f_1$, de durée inférieure à $T_1 = 1/f_1$ et répété périodiquement à la fréquence $f_1$, avec $N$ nombre entier supérieur à 1,
- réalisation de quatrièmes moyens (118) aptes à générer, à partir du signal $S_G$, un signal périodique dont le spectre fréquentiel comporte une raie principale de fréquence $f_2 = (N+i).f_1$, avec $i$ nombre entier, en jouant un rôle de filtre passe-bande appliqué sur le signal $S_G$ et rejetant du spectre fréquentiel dudit signal périodique les raies autres que la raie principale dudit signal périodique.

**Patentansprüche**

1. Frequenzsynthesevorrichtung (100, 200), umfassend wenigstens:

   - erste Mittel (102, 104, 106, 108, 110, 112), die dazu ausgelegt sind, ein periodisches Signal der Frequenz $f_1$ zu erzeugen,
   - zweite und dritte Mittel (114, 116, 202), die mit den ersten Mitteln (102, 104, 106, 108, 110, 112) gekoppelt und dazu ausgelegt sind, am Eingang das periodische Signal der Frequenz $f_1$ zu empfangen und ein Signal $S_G$ entsprechend einem Zug von Oszillationen mit einer Frequenz im Wesentlichen gleich $N.f_1$ mit einer Dauer kleiner als $T_1 = 1/f_1$ und periodisch wiederholt mit der Frequenz $f_1$ zu erzeugen, wobei $N$ eine ganze Zahl größer als 1 ist,
   - vierte Mittel (118), die dazu ausgelegt sind, ausgehend von dem Signal $S_G$ ein periodisches Signal zu erzeugen, dessen Frequenzspektrum eine Hauptlinie der Frequenz $f_2 = (N+i).f_1$ umfasst, wobei i eine ganze Zahl ist, wobei sie die Rolle eines Passbandfilters spielen, der auf das Signal $S_G$ angewandt wird und aus dem Frequenzspektrum des periodischen Signals die anderen Linien als die Hauptlinie des periodischen Signals zurückweisen.

2. Frequenzsynthesevorrichtung (100, 200) nach Anspruch 1, bei der das periodische Signal, dessen Frequenzspektrum die Hauptlinie der Frequenz $f_2$ umfasst, ein im Wesentlichen sinusförmiges Signal ist, das eine im Wesentlichen konstante Einhüllende aufweist.

3. Frequenzsynthesevorrichtung (100, 200) nach einem der vorhergehenden Ansprüche, bei der die zweiten Mittel (114) wenigstens einen spannungsgesteuerten Oszillator umfassen, dessen freier Oszillationsbereich die Frequenz $N.f_1$ enthält, wobei der Wert von $N$ eine Funktion eines Werts einer ersten Steuerspannung ist, die dazu ausgelegt ist, am Eingang des spannungsgesteuerten Oszillators angelegt zu sein.

4. Frequenzsynthesevorrichtung (100) nach Anspruch 3, bei der die dritten Mittel (116) wenigstens einen Unterbrecher umfassen, der mit einem elektrischen Versorgungseingang des Oszillators (114) verbunden und dazu ausgelegt ist, durch das periodische Signal der Frequenz $f_1$ derart gesteuert zu werden, dass er nur während eines Teils jeder Periode $T_1$ eine Versorgungsspannung für den Oszillator (114) ungleich 0 erzeugt.

5. Frequenzsynthesevorrichtung (200) nach Anspruch 3, bei der die dritten Mittel (202) wenigstens einen Unterbrecher umfassen, der mit einem Ausgang des Oszillators (114) verbunden und dazu ausgelegt ist, durch das periodische Signal der Frequenz $f_1$ derart gesteuert zu werden, dass er eine elektrische Verbindung zwischen dem Ausgang des Oszillators (114) und dem Eingang der vierten Mittel (118) während eines Teils jeder Periode $T_1$ unterbricht.

6. Frequenzsynthesevorrichtung (100, 200) nach einem der vorhergehenden Ansprüche, bei der die vierten Mittel (118) wenigstens einen injektionsgesperrten Oszillator umfassen, der dazu ausgelegt ist, am Eingang das Signal $S_G$ zu empfangen und wenigstens periodisch mit der Frequenz $f_2$ gesperrt zu sein, wobei der Wert von i eine Funktion eines Werts einer zweiten Steuerspannung ist, die dazu ausgelegt ist, am Eingang des injektionsgesperrten Oszillators angelegt zu sein.

7. Frequenzsynthesevorrichtung (100, 200) nach einem der vorhergehenden Ansprüche, bei der die vierten Mittel (118) wenigstens ein Passbandfilter mit einer zentralen Frequenz im Wesentlichen gleich $f_2$ umfassen.

8. Frequenzsynthesevorrichtung (100, 200) nach einem der vorhergehenden Ansprüche, bei der der Wert der Frequenz $f_1$ größer als ungefähr 1 GHz ist, und/oder der Wert der Frequenz $f_2$ größer als ungefähr 10 GHz ist, und/oder die Oszillationen des Signals $S_G$ sinusförmig sind.

9. Frequenzsynthesevorrichtung (100, 200) nach einem der vorhergehenden Ansprüche, bei der die ersten Mittel wenigstens eine Resonatorvorrichtung (108) und eine Phasensperrschleife (102, 104, 106, 110, 112) umfassen, die dazu ausgelegt ist, die Phase des periodischen Signals der Frequenz $f_1$, das durch einen spannungsgesteuerten Oszillator (102) der Phasensperrschleife geliefert wird, auf eine Phase eines periodischen Signals zu regeln, das von der Resonatorvorrichtung (108) geliefert wird.

10. Frequenzsynthesevorrichtung (100, 200) nach einem der Ansprüche 1 bis 8, bei der die ersten Mittel eine Resonatorvorrichtung umfassen, die dazu ausgelegt ist, das periodische Signal der Frequenz $f_1$ zu erzeugen.

11. Vorrichtung zum Aussenden und/oder zum Empfangen von Signalen (1000) umfassend wenigstens eine Frequenzsynthesevorrichtung (100, 200) nach einem der vorhergehenden Ansprüche, die mit einem Modulator (1004) und/oder einem Demodulator (1014) der Vorrichtung zum Senden und/oder zum Empfangen (1000) gekoppelt ist.

**12.** Frequenzsyntheseverfahren, umfassend wenigstens die folgenden Schritte:

- Erzeugen eines periodischen Signals der Frequenz $f_1$,
- Erzeugen, ausgehend von dem periodischen Signal der Frequenz $f_1$, eines Signals $S_G$ entsprechend einem Zug von Oszillationen mit einer Frequenz im Wesentlichen gleich $N.f_1$ mit einer Dauer kleiner als $T_1 = 1/f_1$ und periodisch wiederholt mit der Frequenz $f_1$, wobei $N$ eine ganze Zahl größer als 1 ist,
- Erzeugen, ausgehend von dem Signal $S_G$, eines periodischen Signals, dessen Frequenzspektrum eine Hauptlinie der Frequenz $f_2 = (N+i).f_1$ umfasst, wobei i eine ganze Zahl ist, mittels Durchführung einer Passbandfilterungsfunktion, die auf das Signal $S_G$ angewandt wird, wobei aus dem Frequenzspektrum des periodischen Signals die anderen Linien als die Hauptlinie des periodischen Signals zurückgewiesen werden.

**13.** Verfahren zur Herstellung einer Frequenzsynthesevorrichtung (100, 200), umfassend die folgenden Schritte:

- Herstellen von ersten Mitteln (102, 104, 106, 108, 110, 112), die dazu ausgelegt sind, ein periodisches Signal der Frequenz $f_1$ zu erzeugen,
- Herstellen von zweiten und dritten Mitteln (114, 116, 202), die mit den ersten Mitteln (102, 104, 106, 108, 110, 112) gekoppelt und dazu ausgelegt sind, am Eingang das periodische Signal der Frequenz $f_1$ zu empfangen und ein Signal $S_G$ entsprechend einem Zug von Oszillationen mit einer Frequenz im Wesentlichen gleich $N.f_1$ mit einer Dauer kleiner als $T_1 = 1/f_1$ und periodisch wiederholt mit der Frequenz $f_1$ zu erzeugen, wobei N eine ganze Zahl größer als 1 ist,
- Herstellen von vierten Mitteln (118), die dazu ausgelegt sind, ausgehend von dem Signal $S_G$ ein periodisches Signal zu erzeugen, dessen Frequenzspektrum eine Hauptlinie der Frequenz $f_2 = (N+i).f_1$ umfasst, wobei i eine ganze Zahl ist, wobei sie die Rolle eines Passbandfilters spielen, das auf das Signal $S_G$ angewandt wird, und aus dem Frequenzspektrum des periodischen Signals die anderen Linien als die Hauptlinie des periodischen Signals zurückweisen.

## Claims

**1.** Frequency synthesis device (100, 200), comprising at least:

- first means (102, 104, 106, 108, 110, 112) suitable for generating a periodic signal of frequency $f_1$,
- second and third means (114, 116, 202), coupled with the first means (102, 104, 106, 108, 110, 112) and suitable for receiving as an input the periodic signal of frequency $f_1$ and generating a signal $S_G$ corresponding to a train of oscillations of frequency substantially equal to $N.f_1$, of a time less than $T_1 = 1/f_1$ and repeated periodically at the frequency $f_1$, where N is a whole number greater than 1,
- fourth means (118) suitable for generating, from the signal $S_G$, a periodic signal wherein the frequency spectrum comprises a primary line of frequency $f_2 = (N+i).f_1$, where i is a whole number, by acting as a band-pass filter applied to the signal $S_G$ and rejecting from the frequency spectrum of said periodic signal lines other than the primary line of said periodic signal.

**2.** Frequency synthesis device (100, 200) according to claim 1, wherein the periodic signal wherein the frequency spectrum comprises the primary line of frequency $f_2$ is a substantially sinusoidal signal having a substantially constant envelope.

**3.** Frequency synthesis device (100, 200) according to one of previous claims, wherein the second means (114) comprise at least one voltage-controlled oscillator wherein the free oscillation range includes the frequency $N.f_1$, the value of N being dependent on a value of a first control voltage to be applied at the input of the voltage-controlled oscillator.

**4.** Frequency synthesis device (100) according to claim 3, wherein the third means (116) comprise at least one switch connected to an electrical power supply input of the oscillator (114) and suitable for being controlled by the periodic signal of frequency $f_1$ such that it generates a non-zero power supply voltage of the oscillator (114) only for a portion of each period $T_1$.

**5.** Frequency synthesis device (200) according to claim 3, wherein the third means (202) comprise at least one switch connected to an output of the oscillator (114) and suitable for being controlled by the periodic signal of frequency $f_1$ such that it breaks an electrical connection between the oscillator (114) output and the input of the fourth means (118) during a portion of each period $T_1$.

**6.** Frequency synthesis device (100, 200) according to one of previous claims, wherein the fourth means (118) comprise at least one injection-locked oscillator intended to receive, as an input, the signal $S_G$ and to be locked at least periodically at the frequency $f_2$, the value of $i$ being dependent on a value of a second control voltage intended to be applied at the input of the injection-locked oscillator.

**7.** Frequency synthesis device (100, 200) according to one of previous claims, wherein the fourth means (118) comprise at least one band-pass filter of central frequency substantially equal to $f_2$.

**8.** Frequency synthesis device (100, 200) according to one of previous claims, wherein the value of the frequency $f_1$ is greater than approximately 1 GHz, and/or the value of the frequency $f_2$ is greater than approximately 10 GHz, and/or the oscillations of the signal $S_G$ are sinusoidal.

**9.** Frequency synthesis device (100, 200) according to one of previous claims, wherein the first means comprise at least one resonating device (108) and a phase-locked loop (102, 104, 106, 110, 112) suitable for controlling the phase of the periodic signal of frequency $f_1$ output by a voltage-controlled oscillator (102) of the phase-locked loop on a phase of a periodic signal output by the resonating device (108).

**10.** Frequency synthesis device (100, 200) according to one of claims 1 to 8, wherein the first means comprise a resonating device suitable for generating the periodic signal of frequency $f_1$.

**11.** Signal transmission and/or reception device (1000), comprising at least one frequency synthesis device (100, 200) according to one of previous claims coupled with a modulator (1004) and/or a demodulator (1014) of the transmission and/or reception device (1000).

**12.** Frequency synthesis method, comprising at least steps for:

- generating a periodic signal of frequency $f_1$.
- generating, from the periodic signal of frequency $f_1$, a signal $S_G$ corresponding to a train of oscillations of frequency substantially equal to $N.f_1$, of a time less than $T_1 = 1/f_1$ and repeated periodically at the frequency $f_1$, where N is a whole number greater than 1,
- generating, from the signal $S_G$, a periodic signal wherein the frequency spectrum comprises a primary line of frequency $f_2 = (N+i).f_1$, where i is a whole number, using a band-pass filtering function applied to the signal $S_G$ and rejecting from the frequency spectrum of said periodic signal lines other that the primary line of said periodic signal.

**13.** Method for producing a frequency synthesis device (100, 200), comprising at least steps for:

- producing first means (102, 104, 106, 108, 110, 112) suitable for generating a periodic signal of frequency $f_1$,
- producing second and third means (114, 116, 202), coupled with the first means (102, 104, 106, 108, 110, 112) and suitable for receiving, as an input, the periodic signal of frequency $f_1$ and for generating a signal $S_G$ corresponding to a train of oscillations of frequency substantially equal to $N.f_1$, of a time less than $T_1 = 1/f_1$ and repeated periodically at the frequency $f_1$, where N is a whole number greater than 1,
- producing fourth means (118) suitable for generating, from the signal $S_G$, a periodic signal wherein the frequency spectrum comprises a primary line of frequency $f_2 = (N+i).f_1$, where i is a whole number, by acting as a band-pass filter applied to the signal $S_G$ and rejecting from the frequency spectrum of said periodic signal the lines other than the primary line of said periodic signal.

f1

12

14

10

f1/N

16

fquartz

20

18

# FIG. 1

30

f1=N.fquartz

fquartz

16

32

# FIG. 2

**FIG. 3**

**FIG. 4**

FIG. 5A

FIG. 6A

FIG. 5B

FIG. 6B

$T_2 = 1/f_2$

SIGNAL $S_2$

TEMPS

## FIG. 7A

SIGNAL $S_2$

$f_2 = Nf_1$   FREQUENCE

## FIG. 7B

## FIG. 8

## FIG. 10

FIG. 9A

FIG. 9B

FIG. 11

FIG. 12

FIG. 13

FIG. 15

FIG. 14A

FIG. 14B

## RÉFÉRENCES CITÉES DANS LA DESCRIPTION

**Documents brevets cités dans la description**

- WO 2008069444 A1

**Littérature non-brevet citée dans la description**

- **A. SILIGARIS et al.** *Silicon Monolithic Integrated Circuits in RF Systems (SiRF), 2011 IEEE 11th Topical Meeting,* 17 Janvier 2011, vol. A 60 GHz UWB impulse radio transmitter with integrated antenna in CMOS65nm SOI technology, 153-156
- **O. RICHARD et al.** A 17.5-to-20.94GHz and 35-to-41.88GHz PLL in 65nm CMOS for wireless HD applications. *Solid-State Circuits Conférence Digest of Technical Papers (ISSCC), 2010 IEEE International,* 07 Février 2010, 252-253

- **M. TIEBOUT.** A 50 GHz direct injection locked oscillator topology as low power frequency divider in 0.13 $\mu$m CMOS. *Solid-State Circuits Conference, 2003. ESSCIRC '03. Proceedings of the 29th European,* 16 Septembre 2003, 73-76